(19) Europäisches Patentamt
European Patent Office
Office européen des brevets

(11) Veröffentlichungsnummer: **0 283 496 B1**

(12) **EUROPÄISCHE PATENTSCHRIFT**

(45) Veröffentlichungstag der Patentschrift: **02.06.93**

(51) Int. Cl.5: **H01L 29/91**, H01L 29/08

(21) Anmeldenummer: **87906183.6**

(22) Anmeldetag: **25.09.87**

(86) Internationale Anmeldenummer:
**PCT/EP87/00544**

(87) Internationale Veröffentlichungsnummer:
**WO 88/02555 (07.04.88 88/08)**

(54) **HALBLEITERBAUELEMENT MIT EINER ANODENSEITIGEN P-ZONE UND EINER ANLIEGENDEN SCHWACH DOTIERTEN N-BASISZONE.**

(30) Priorität: **30.09.86 DE 3633161**

(43) Veröffentlichungstag der Anmeldung:
**28.09.88 Patentblatt 88/39**

(45) Bekanntmachung des Hinweises auf die Patenterteilung:
**02.06.93 Patentblatt 93/22**

(84) Benannte Vertragsstaaten:
**CH DE FR GB LI SE**

(56) Entgegenhaltungen:
**EP-A- 0 135 733**
**EP-A- 0 157 207**

**PATENT ABSTRACTS OF JAPAN, vol. 10, no. 192, (E-417)(2248), 5 July 1986, & JP-A-6139575**

**PATENT ABSTRACTS OF JAPAN, vol. 7, no. 226 (E-202)(1371), 7 October 1983, & JP-A-58115871**

**PATENT ABSTRACTS OF JAPAN, vol. 5, no. 103 (E-64)(775), 3 July 1981, & JP-A-5645081**

**NEUES AUS DER TECHNIK, No.3, 15 June 1981, Vogel-Verlag, (Würzburg, DE), "Schnelle Diode", page 1.**

(73) Patentinhaber: **EUPEC Europäische Gesellschaft für Leistungshalbleiter mbH & Co. KG**
**Max-Planck-Strasse 5**
**W-4788 Warstein/Belecke(DE)**

(72) Erfinder: **SCHLANGENOTTO, Heinrich, Dr.**
**Jahnstrasse 34**
**W-6078 Neu-Isenburg(DE)**
Erfinder: **SOMMER, Karl Heinz, Dr.**
**Goethestrasse 12**
**W-4788 Warstein(DE)**

(74) Vertreter: **Fuchs, Franz-Josef, Dr.-Ing. et al**
**Postfach 22 13 17**
**W-8000 München 22 (DE)**

## Beschreibung

Die Erfindung bezieht sich auf ein Halbleiterbauelement nach dem Oberbegriff des Patentanspruchs 1.

Ein solches Halbleiterbauelement ist z. B. in der europäischen Patentanmeldung 0 157 207 beschrieben worden. Gegenstand dieses Dokuments ist ein GTO-Thyristor, dessen anodenseitige P-Zone aus einer eigenleitenden Zone und einer darin eingebetteten stärker dotierten P-Teilzone besteht. Der Zweck dieses Aufbaus besteht darin, das anodenseitige Injektionsverhalten des GTO-Thyristors zu verbessern. Damit sollen hohe Ströme abgeschaltet werden können.

Leistungsgleichrichterdioden haben eine $P^+NN^+$-Zonenstruktur, bestehen also aus zwei hochdotierten Zonen vom P- bzw. N-Leitfähigkeitstyp, die an die Oberfläche der Halbleiterscheibe angrenzen, und einer dazwischenliegenden, schwach dotierten Zone, die im allgemeinen N-Leitfähigkeit besitzt. Von schnellen Gleichrichterdioden wird außer einer genügend kleinen Durchlaßspannung und einem genügend kleinen Sperrstrom gefordert, daß bei Kommutierung aus dem Durchlaßwiderstand die Rückstromspitze und die Speicherzeit klein sein und insbesondere der Abfall des Rückstroms nach dem Rückstrommaximum mit geringer Steilheit erfolgen sollen (Soft-Recovery-Verhalten). Ein bekanntes Mittel, dies bis zu einem gewissen Grad zu erreichen, besteht in der Reduzierung der Trägerlebensdauer durch Rekombinationszentren, wie Gold, Platin oder die durch Elektronen-, Gamma- oder Protonenbestrahlung erzeugten Defekte.

Ein Nachteil dieser Methode ist, daß der Sperrstrom proportional zur Rekombinationszentrendichte zunimmt und bei den besonders effektiven Rekombinationsniveaus nahe der Mitte der Bandlücke zu hoch werden kann. Dieser Effekt ist beim Gold, das wegen seiner sonstigen günstigen Eigenschaften am häufigsten verwendet wird, bei höheren Temperaturen sehr störend; er begrenzt die zulässige Goldkonzentration und damit den Grad der Verbesserung des Recovery-Verhaltens.

Auch mit Rücksicht auf die Durchlaßspannung darf die Rekombinationszentrendichte nicht zu hoch, d. h. die Trägerlebensdauer nicht zu klein gewählt werden. Wird das Verhältnis Basisdicke/$\sqrt{D\tau}$ (D ambipolare Diffusionskonstante, $\tau$ Trägerlebensdauer bei hoher Injektion) größer als 2, steigt die Durchlaßspannung exponentiell mit $N_{Rek} \sim 1/\tau$ an und wird zu groß. Mit $\tau$ wird auch die für das Recovery-Verhalten wichtige Speicherladung nach unten begrenzt. Eine zusätzliche Einschränkung ergibt sich daraus, daß die Rekombinationszentrenkonzentration zur Vermeidung einer zu weitgehenden Kompensation deutlich unter der gewöhnlichen Leitfähigkeitsdotierung der N-Basiszone liegen muß, die ihrerseits durch das gewünschte Sperrvermögen festgelegt ist. Ist diese Bedingung nicht erfüllt, so ergeben sich bei Anlegen eines Strompulses anfänglich zu hohe dynamische Spannungsspitzen und die Durchlaßerholzeit, nach der die Durchlaßspannung sich bis auf 10 % der anfänglichen Überhöhung dem stationären Wert angenähert hat, wird zu groß. Auch hieraus folgt für die einzustellende Trägerlebensdauer eine untere Grenze, die nicht unterschritten werden darf. Es hat sich gezeigt, daß diese Begrenzung in vielen Fällen einschneidender ist als die durch das stationäre Durchlaßverhalten.

Die Ortsverteilung der Rekombinationszentren ist im allgemeinen weitgehend durch die jeweilige Technologie vorgegeben, kann also nicht ohne weiteres so gewählt werden, wie es für ein optimales Gleichrichterverhalten erforderlich wäre. Nur bei der Methode der Protonenbestrahlung sind sehr günstige Zentrenverteilungen erreichbar. Jedoch ist die Protonenbestrahlung ein aufwendiges Verfahren, das bisher in der Halbleiterfertigung nicht eingesetzt wird. Auch die anderen Bestrahlungsverfahren haben den Nachteil, daß mit ihnen eine Trägerlebensdauereinstellung in den Fertigungsstätten selbst im allgemeinen nicht durchgeführt werden kann.

Zur Verbesserung des Recovery-Verhaltens von Gleichrichterdioden ist aus der EP-OS 0090722 eine Halbleiter-Struktur bekannt, bei welcher zwischen der schwach dotierten N-Basiszone und dem hoch dotierten $N^+$-Gebiet eine N-Zone mittlerer Dotierungskonzentration angeordnet ist, die in dem Bereich $10^{14}$ bis $10^{16}$/cm³ liegt. Für die Herstellung dieser Zwischenzone ist ein beträchtlicher technischer Aufwand erforderlich, da diese Zone in dem Ausgangssilizium durch epitaktisches Aufwachsen erzeugt oder durch zusätzliche Diffusionsschritte angenähert werden muß. Insbesondere ist die so erreichte Verbesserung der Diodeneigenschaften nur gering, weil der Aufbau der Raumladungszone bei dem plötzlichen Anstieg der Spannung zur Zeit der Rückstromspitze vornehmlich durch die zur Anode fließenden freien Löcher in der Struktur bestimmt wird, die die positive Raumladung stark erhöhen. Die Raumladungszone stößt daher bei Erreichen der Rückstromspitze nicht in kurzer Zeit bis zu der Zone mittlerer Dotierungskonzentration vor, so daß diese Zone das Recovery-Verhalten erst beeinflußt, wenn der Rückstrom schon klein ist.

Es ist weiter eine $PNN^+$-Gleichrichterdiode bekannt (TEEE Trans. Electron Dev. ED-31, 1984, S. 1314), bei welcher die Dotierungskonzentration $\rho$ und Dicke w der anodenseitigen P-Zone in lateral kleinen Channelbereichen gering ist, z. B. $\rho = 5\times10^{15}$/cm³ und w = 1 μm, in den anderen Flä-

chenbereichen aber wesentlich größer, z. B. $\rho$ = $4\times10^{18}$/cm³ und w = 5 $\mu$m. Die laterale Ausdehnung der Channelbereiche liegt in der Größenordnung 2 $\mu$m. Die P-Zonen-Bereiche geringer Dotierungskonzentration und Dicke haben eine geringe Konzentration injizierter Ladungsträger an der P-Seite der N-Basiszone bei Durchlaßbetrieb zur Folge, woraus sich ein gutes Recovery-Verhalten ergibt. Bei Sperrbelastung werden die Channelbereiche statisch abgeschirmt, so daß die Raumladungszone trotz der geringen Dotierungskonzentration und Dicke der P-Zone in diesen Bereichen nicht bis an die Oberfläche dringt. Ein Nachteil dieser Struktur besteht darin, daß auf diese Weise nur Sperrfähigkeiten bis etwa 150 V erreicht werden und daß die Struktur für hohe Spannungen auch deshalb ungeeignet ist, weil die Durchlaßspannung dann zu groß wird. Ein anderer Nnachteil ist, daß einzelne Abweichungen und Fehler in der lateralen P-Zonenstruktur einen weitgehenden Verlust des Sperrvermögens zur Folge haben können, so daß der Ausschuß bei großflächigen Dioden dieser Art für eine wirtschaftliche Anwendung zu groß wird.

Ferner ist eine Diode mit verringerter Ladungsspeicherung bekannt, bei der außerdem die in Flußrichtung abfallende Spannung niedrig ist (Zeitschrift "Neues aus der Technik" (1981), Juni, Nr. 3, Seite 1). Hierzu wird vorgeschlagen, in die anodenseitige P-Zone Gebiete vom entgegengesetzten Leitfähigkeitstyp einzubetten, die mit der Anodenzone kurgeschlossen sind. Eine andere bekannte Diode mit geringem Vorwärtsspannungsabfall und kurzer Erholungszeit hat eine P⁻-dotierte Innenzone an die sich stark P-dotierte Außenzone und daran eine stark P-dotierte, aus polykristallinem Silizium bestehende Außenzone anschließt (Patent Abstracts of Japan, Band 10, No. 192 (E-417) [2248], 5. July 1986 und JP-A-61-39375).

Von schnellen Thyristoren wird außer einer kleinen Freiwerdezeit gefordert, daß bei Kommutierung aus dem Durchlaßzustand die Rückstromspitze und das Rückstromintegral klein sein sollen. Diese Forderung wird, ähnlich wie vorstehend für Gleichrichterdioden beschrieben, bei den bekannten Thyristoren nur unzureichend durch die Dotierung mit Rekombinationszentren realisiert, weil deren Anwendbarkeit durch die Nebenforderung ausreichender Durchlaßeigenschaften und eines genügend kleinen Sperrstroms beschränkt ist.

Der Erfindung liegt die Aufgabe zugrunde, ein Halbleiterbauelement mit einer anodenseitigen P-Zone und einer anliegenden schwach dotierten N-Zone zu schaffen, welches ein verbessertes Recovery-Verhalten bei Kommutierung mit guten Durchlaßeigenschaften und geringem Sperrstrom vereint und technisch einfach für einen weiten Strom- und Spannungsbereich herstellbar ist.

Diese Aufgabe wird durch die im Anspruch 1 gekennzeichneten Merkmale gelöst.

Vorteilhafte Weiterbildungen der Erfindung sind in den Unteransprüchen gekennzeichnet.

Die durch die Erfindung erzielten Vorteile bestehen darin, daß bei dem Halbleiterbauelement die Rückwärtsstromspitze stark reduziert und die Abnahme des Rückstromes nach dem Maximum flach ist. Der Sperrstrom ist verringert, so daß das Halbleiterbauelement für höhere Betriebstemperaturen eingesetzt werden kann. Ferner ist das Halbleiterbauelement ohne technisch aufwendige Bestrahlungsverfahren und ohne die für Feldeffektbauelemente erforderliche Maskierungsfeinheit auch mit großer Fläche in hoher Ausbeute herstellbar.

Die Erfindung wird nachstehend anhand von in den Figuren schematisch dargestellten Ausführungsbeispielen näher erläutert. Es zeigen

Fig. 1      eine prinzipielle Gleichrichterdiodenstruktur gemäß der Erfindung und den Verlauf der Ladungsträgerverteilung in den Zonen derselben,

Fig. 2      ein Diagramm mit dem zeitlichen Verlauf des Rückstromes bei einer Gleichrichterdiode gemäß der Erfindung und bei einer nach dem Stand der Technik,

Fig. 3      eine Ausbildung einer Gleichrichterdiode gemäß der Erfindung,

Fig. 4      ein Dotierungsprofil der Zonenstruktur bei einer nach Fig. 3 ausgebildeten Gleichrichterdiode,

Fig. 5      Verteilungen injizierter Ladungsträger in einer Gleichrichterdiode nach Fig. 3 bei verschiedenen Durchlaßstromdichten,

Fig. 6      eine weitere Ausbildung einer Gleichrichterdiode gemäß der Erfindung mit lateral sich abwechselnden Bereichen hoher und niedriger P-Emitterwirksamkeit,

Fig. 7      die laterale Verteilung der Löcherkonzentration in einer Gleichrichterdiode nach Fig. 6 bei verschiedenen Elektronenstromdichten,

Fig. 8      den Maximalwert der injizierten Löcherkonzentration in Abhängigkeit vom Radius der Bereiche hoher P-Emitterwirksamkeit der Gleichrichterdiode nach Fig. 6,

Fig. 9      Verteilungen injizierter Ladungsträger in einer Gleichrichterdiode nach Fig. 6 bei verschiedenen Durchlaßstromdichten,

Fig. 10      eine weitere Ausbildung einer Gleichrichterdiode gemäß der Erfindung,

Fig. 11      Dotierungsprofile der Zonenstruktur bei einer nach Fig. 10 ausgebildeten Gleichrichterdiode,

Fig. 12 die Ausbildung eines erfindungsgemäßen Thyristors.

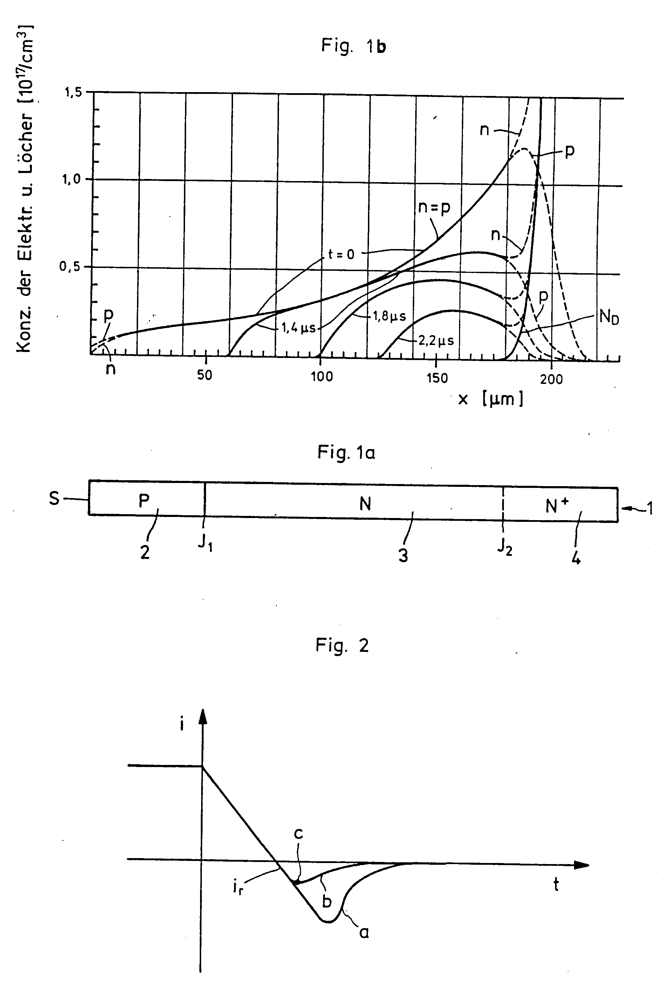

Die Fig. 1a zeigt eine Gleichrichterdiode 1 mit einer Elektronensenke S in der P-Zone 2 zur Verbesserung des Recovery-Verhaltens. Die Elektronensenke kann entweder durch die Oberfläche oder, wie weiter unten ausgeführt, durch N-Zonen in der P-Zone 2 ausgebildet sein, wobei die P-Zone 2 vor der Elektronensenke S nur so schwach dotiert ist, daß das Gebiet hoher Injektionen bei Durchlaßbelastung bis nahe an die Elektronensenke S heranreicht. Die Dotierung vor der Elektronensenke ist jedoch groß genug, daß die Raumladungszone bei Sperrbelastung sich nicht bis zur Elektronensenke ausdehnt. Wie nicht weiter dargestellt, weist die P-Zone 2 zur ohmschen Kontaktierbarkeit an der Oberfläche wenigstens in Teilbereichen eine Zone hoher Dotierungskonzentration auf. Nach innen schließt sich an die P-Zone 2 eine schwach dotierte N-Basiszone 3 und an diese eine hoch dotierte $N^+$-Zone 4 an.

In dem Diagramm der Fig. 1b sind die Elektronen- und Löcherverteilungen in der Diode nach Fig. 1a bei Durchlaßbetrieb (t = o) und zu verschiedenen Zeitpunkten nach Beginn der Umkommutierung dargestellt. In dem Bereich hoher Injektion mit vernachlässigbarer Dotierungskonzentration sind Elektronenkonzentration n und Löcherkonzentration p gleich. Die Kurvenzüge für n und p laufen nur am $NN^+$-Übergang $J_2$ mit ansteigender Dotierungskonzentration $N_D$ stark auseinander.

Wie aus dem Diagramm ersichtlich, bewirkt die in der P-Zone 2 vorgesehene Elektronensenke S eine starke Absenkung der Konzentration injizierter Ladungsträger bei Durchlaßbelastung an der P-Seite im Bereich des PN-Übergangs $J_1$. Die Ladungsträgerkonzentration am PN-Übergang $J_1$ beträgt beispielsweise nur etwa $2 \times 16^{16}$/$cm^3$, am $NN^+$-Übergang $J_2$ aber mehr als $1 \times 10^{17}$/$cm^3$. Infolge dieser unsymmetrischen Ladungsträgerverteilung wird der PN-Übergang $J_1$ beim Kommutierungsvorgang schnell von Ladungsträgern freigeräumt, wie aus den Ladungsträgerverteilungen für t = 1,4 $\mu$s, 1,8 $\mu$s und 2,2 $\mu$s nach Beginn der Umkommutierung hervorgeht. Schon bei t = 1,4 $\mu$s ist die Konzentration injizierter Ladungsträger in der näheren Umgebung des PN-Übergangs $J_1$ gleich null, so daß sich eine Raumladungszone und eine entsprechende Sperrspannung aufgebaut hat, die der äußeren Spannung entgegengerichtet ist. Da der Rückstrom $i_r$ mit dem Beginn der Sperrspannungsaufnahme abzufallen beginnt, ist die Zeit bis zum Einreichen der Rückstromspitze daher gering, was bei der üblichen Kommutierung mit konstanten di/dt auch eine geringe Rückstromspitze selbst zur Folge hat. Trotz der schon hohen Spannung an der Diode ist aber in dem N-Basisbereich in der Nähe der N-Zone 4 noch viel Ladung gespeichert, wie ebenfalls aus Fig. 1 hervorgeht. Der Strom kann daher nicht scharf abreißen, so daß sich das aus Fig. 2 ersichtliche ausgeprägte Soft-Recovery-Verhalten der Gleichrichterdiode ergibt. In der Fig. 2 zeigt die Kurve a den zeitlichen Verlauf des Rückstromes $i_r$ bei einer Gleichrichterdiode nach dem Stand der Technik, während Kurve b den zeitlichen Verlauf des Rückstromes $i_r$ bei einer Gleichrichterdiode nach dem Stand der Technik, während Kurve b den zeitlichen Verlauf des Rückstromes $i_r$ bei einer Gleichrichterdiode gemäß der Erfindung zeigt. Wie ersichtlich, ist die Rückstromspitze c bei der erfindungsgemäßen Gleichrichterdiode stark reduziert, und die Abnahme des Rückstromes $i_r$ nach dem Maximum verläuft wesentlich flacher.

Die vorstehend auf die erfindungsgemäße Gleichrichterdiode bezogenen Ausführungen gelten im wesentlichen auch für die Umkommutierung eines Thyristors mit ähnlicher Ladungsträgerverteilung bei Durchlaßbetrieb.

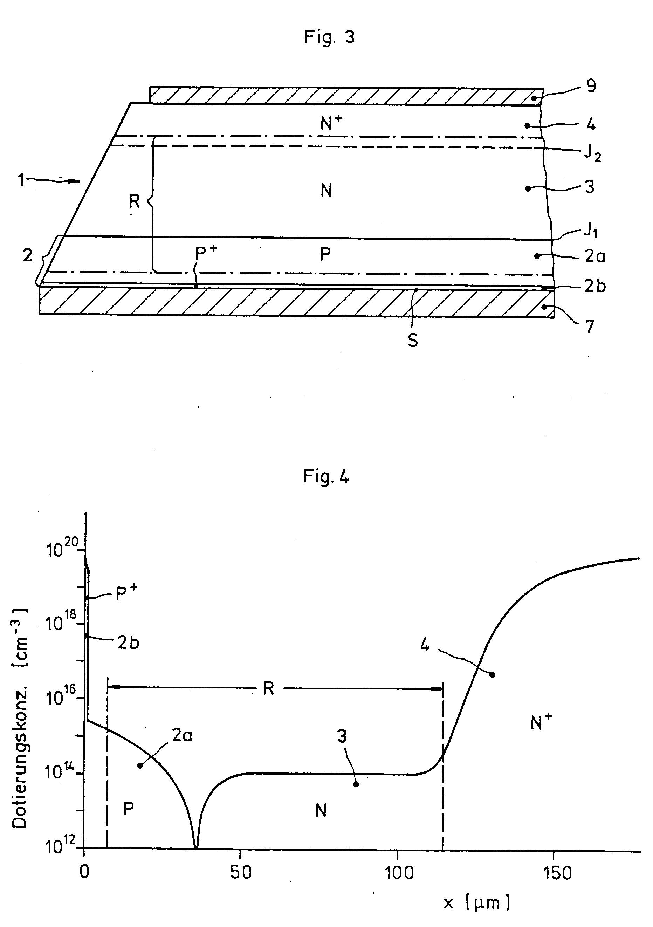

Bei der Ausbildung der Gleichrichterdiode nach der Fig. 3 besteht die P-Zone 2 aus einer dicken schwach dotierten inneren P-Teilzone 2a und einer dünnen hochdotierten $P^+$-Oberflächenzone 2b, mit der die Halbleiterscheibe auf eine Trägerplatte 7 auflegiert oder aufgelötet ist. An die P-Teilzone 2a schließt sich eine schwach dotierte N-Basiszone 3 und daran eine hoch dotierte $N^+$-Zone 4 an, die an ihrer Oberfläche mit einer ohmschen Kontaktierungsschicht 9 versehen ist. Der PN-Übergang $J_1$ zwischen der P-Teilzone 2a und der N-Basiszone 3 nimmt die Sperrspannung auf. Zur Oberflächenpassivierung ist die Gleichrichterdiode mit einem Schrägschliff versehen.

Wie aus dem in Fig. 4 dargestellten Dotierungsprofil der Gleichrichterdiode nach Fig. 3 ersichtlich, hat der schwach dotierte Bereich 2a der P-Zone 2 nur eine Oberflächenkonzentration zwischen $1 \times 10^{15}$/$cm^3$ und $1 \times 10^{16}$/$cm^3$; seine Dicke beträgt beispielsweise 40 $\mu$m. Bei Sperrbelastung dehnt sich die Raumladungszone R auf der P-Seite nur innerhalb dieser Zone aus, reicht also auch bei der maximalen Sperrbelastung nicht bis zur Oberfläche. Durch diese im allgemeinen diffundierte Zone wird in bekannter Weise eine hohe Sperrfähigkeit ermöglicht. Bei Durchlaßbetrieb dagegen reicht das Gebiet mittlerer bis hoher injizierter Ladungsträgerkonzentration schon von kleinen Stromdichten, z. B. 5 A/$cm^2$, an aufwärts bis dicht an die Oberfläche heran, so daß diese als effektive Elektronensenke wirkt. Die dünne $P^+$-Oberflächenzone 2b dient nur zur ohmschen Kontaktierung und besitzt eine dafür ausreichende Dotierungskonzentration, die in der Regel größer als $3 \times 10^{17}$/$cm^3$ ist. Die Dicke der Oberflächenzone 2b wird so klein gewählt, daß die von der $N^+$-Zone 4 kommenden Elektronen durch sie nur in geringem Maße daran gehindert werden, zur Elektronensenke an der Oberfläche zu fließen, wo sie rekombinieren oder durch einen Tunnelprozeß in das Metall übertreten. Vorteilhaft wird die Dicke kleiner als 2 $\mu$m gewählt, beispielsweise gleich 0,2 $\mu$m. Wie anhand der Fig. 1 erläutert, wird dadurch die Ladungsträgerkonzentration an der P-Seite bei Strömen oberhalb von z. B. 5 A/cm$^2$ stark abgesenkt. Daraus ergibt sich die gewünschte Verbesserung des Recovery-Verhaltens. Die Gleichrichterdiode ist vorteilhaft zusätzlich mit Rekombinationszentren dotiert, soweit es die Durchlaßspannung erlaubt, die sowohl durch die Rekombinationszentren als auch durch die erfindungsgemäße Ausbildung der P-Zone 2 erhöht wird. Da die Rekombinationszentrendichte aus diesem Grunde geringer ist als in den vergleichbaren bekannten Gleichrichterdiode, ist auch der Sperrstrom entsprechend geringer.

Die Bedingung, daß die Raumladungszone R bei der maximalen Sperrbelastung noch innerhalb der schwach dotierten P-Teilzone 2a verläuft, andererseits das Gebiet mittlerer bis hoher Injektion bei Durchlaßbelastung bis nahe an die Oberfläche heranreicht, läßt sich mit Hilfe der integralen Dotierung $N_{int}$ = $\int$Ndx, das ist die Flächenbelegung mit Dotieratomen, der P-Teilzone 2a ausdrücken. Damit das Sperrvermögen gewährleistet ist, wird $N_{int}$ größer als etwa 1,3 x 10$^{12}$/cm$^2$ gewählt, damit die Oberfläche bei Durchlaßpolung der Diode eine effektive Elektronensenke bildet, ist $N_{int}$. vorteilhaft kleiner als etwa 1 x 10$^{13}$/cm$^2$. Annähernd gleichbedeutend damit ist folgende Bedingung für den Flächenwiderstand R der P-Teilzone 2a:

$$1,5 \ K\Omega \leq R_\square \leq 10 \ K\Omega$$

Zur Erzielung einer guten Ausbeute bei höher sperrenden Bauelementen ist es weiter vorteilhaft, die Dicke der P-Teilzone 2a größer als 5 $\mu$m zu wählen. Aus Gründen, die mit der Passivierung und dem Durchlaßspannungsabfall zusammenhängen, wird die Dicke andererseits vorteilhaft kleiner als 70 $\mu$m gewählt. Unter Berücksichtigung der Bedingungen für die integrale Dotierung bzw. den Flächenwiderstand wird die maximale Dotierungskonzentration der P-Teilzone 2a zweckmäßig zwischen 1 x 10$^{15}$/cm$^3$ und 2 x 10$^{16}$/cm$^3$ gewählt.

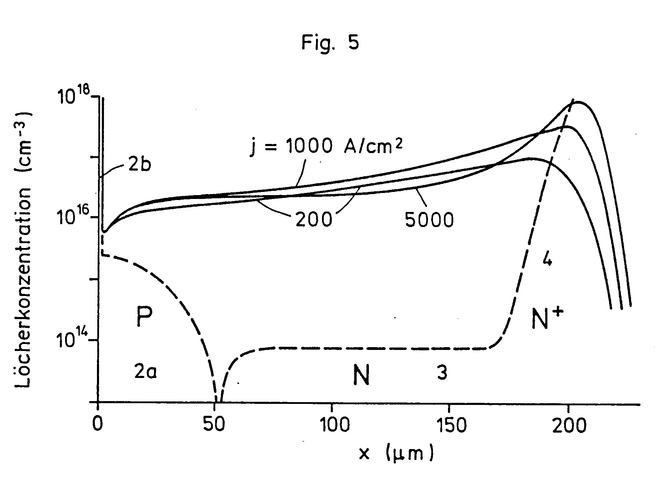

Es hat sich gezeigt, daß Gleichrichterdioden nach Fig. 3 und 4 bis für ein Sperrvermögen von etwa 1000 V bei angepaßter Dotierung mit Rekombinationszentren auch den Anforderungen bezüglich der Durchlaßdaten genügen und somit insgesamt eine wesentliche Verbesserung gegenüber dem Stand der Technik darstellen. Bei Auslegung der N-Basiszone 3 für höhere Sperrspannungen hält sich die Durchlaßspannung zwar für betriebsmäßige Strombelastungen von etwa 200 A/cm$^2$ bei

nicht zu großen N-Basisdicken noch immer in den zulässigen Grenzen, doch nimmt die Durchlaßspannung bei hohen Stromdichten, wie sie im Überstromfall (Kurzschlußfall) auftreten, unerwartet stark zu, so daß die Überstromfestigkeit stark reduziert ist. Die Ursachen dafür werden anhand der Fig. 5 erläutert, in welcher Löcherverteilungen in einer Gleichrichterdiode nach Fig. 3 und 4 für verschiedene Durchlaßstromdichten aufgetragen sind. Der Dotierungsverlauf ist gestrichelt eingezeichnet. Für eine Betriebsstromdichte von 200 A/cm$^2$ ergibt sich die dargestellte unsymmetrische Löcherverteilung, die im Bereich schwacher Dotierung mit der Elektronenverteilung übereinstimmt. Mit steigendem Strom nimmt die Ladungsträgerkonzentration zunächst noch zu, wie ein Vergleich mit dem Kurvenzug für 1000 A/cm$^2$ zeigt. Mit weiter ansteigendem Strom dehnt sich das Gebiet reduzierter Ladungsträgerkonzentration an der P-Seite der N-Basiszone 3 zunehmend bis in die N$^+$-seitige Hälfte der N-Basiszone 3 aus ,wie aus dem Kurvenzug für 5000 A/cm$^2$ hervorgeht. Da die gespeicherte ladung in dieser Diode nicht mehr zunimmt, ergibt sich eine starke Zunahme der Spannung mit dem Strom und somit eine geringe Überstromfestigkeit.

Eine Anhebung der Oberflächenkonzentration der P-Zone 2a (Fig. 3, 4) hat eine entsprechende Anhebung der Ladungsträgerkonzentration bei hohen Stromdichten und damit eine Verbesserung der Überstromfestigkeit zur Folge. Auch durch Vergrößerung der Dicke der hochdotierten Oberflächenzone 2b kann eine vorgegebene Überstromfestigkeit erreicht werden. Das Recovery-Verhalten wird durch beide Maßnahmen allerdings beeinträchtigt, da die Effektivität der Elektronensenke an der Oberfläche und damit die Unsymmetrie der Ladungsträgerverteilung bei Betriebsströmen vermindert wird. Trotzdem wird auf diese Weise mit der Gleichrichterstruktur nach Fig. 3 und 4 bei vorgegebenem zulässigen Überstrom ein besseres Recovery-Verhalten erzielt als mit den bekannten Gleichrichterdioden.

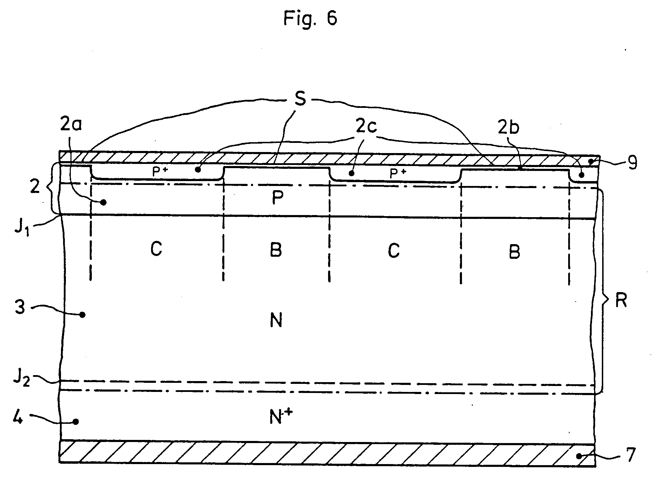

Eine weitere Verbesserung wird dadurch erreicht, daß die Elektronensenke S flächenmäßig nur in Teilbereichen der P-Zone 2 als wirksam angeordnet ist, während das Injektionsvermögen der P-Zone 2 in den Zwischenbereichen hoch ist. Eine solche Anordnung zeigt die Gleichrichterstruktur nach Fig. 6. An die N$^+$-Zone 4, mit der die Halbleiterscheibe leitend auf eine Trägerplatte 7 aufgebracht ist, schließt sich die schwach dotierte N-Baiszone 3 und an diese die P-Zone 2 an, die an ihrer Oberfläche mit einer ohmschen Kontaktierungsschicht 9 versehen ist. Die P-Zone 2 weist außer der durchgehenden schwach dotierten Teilzone 2a, die wie bei der Gleichrichterdiode nach Fig. 3 mit der N-Basiszone 3 den sperrenden PN-Übergang J$_1$ bildet, in den Bereichen B eine dünne hoch dotierte $P^+$-Zone 2b auf, die in diesen Bereichen zur Kontaktierung dient, und in den Teilbereichen C relativ dicke hoch dotierte $P^+$-Zonen 2c, die eine hohe Emitterwirksamkeit besitzen. Die P-Zone 2 hat in den Bereichen B einen Dotierungsverlauf wie bei der Gleichrichterdiode nach Fig. 3 und 4; bei der Dotierungskonzentration der schwach dotierten Teilzone 2a und der Dicke der hoch dotierten Teilzone 2b braucht keine Rücksicht auf die Überstromfestigkeit genommen zu werden, da diese durch die Zonen 2c erreicht wird.

Da die P-Zone in den Bereichen B bis auf die dünne Oberflächenzone 2b schwach dotiert ist, reicht das Gebiet mittlerer bis hoher injizierter Ladungsträgerkonzentration bei Durchlaßbetrieb bis dicht an die Oberfläche heran, so daß diese in den Bereichen B als effektive Elektronensenke wirkt. Die Senke S bewirkt eine starke Absenkung der lateral gemittelten Ladungsträgerkonzentration am PN-Übergang $J_1$, so daß das Recovery-Verhalten gegenüber den bekannten Gleichrichterdioden wesentlich verbessert ist. Die hoch dotierten $P^+$-Zonen 2c haben gegenüber der Gleichrichterdiode nach Fig. 3 eine Verbesserung der Überstromfestigkeit zur Folge, weil sie eine Zunahme der gespeicherten Ladung mit dem Strom bewirken, während die Speicherladung der Gleichrichterdiode nach Fig. 3 bei hohen Stromdichten nur wenig oder gar nicht mehr zunimmt, wie in Verbindung mit Fig. 5 erläutert. Die Erhöhung der Speicherladung mit dem Strom in der Gleichrichterdiode nach Fig. 6 wird noch dadurch verstärkt, daß der Strom sich mit wachsendem Strom aus den Bereichen B mit kleiner P-Emitterwirksamkeit zunehmend in die Bereiche C mit hoher P-Emitterwirksamkeit verlagert, weil das Leitvermögen dort ansteigt. Durch die erhöhte Stromdichte in den Bereichen C wird aber die Speicherladung und damit das Leitvermögen dort weiter erhöht. In den Bereichen B, wo die Stromdichte bei gegebenem Gesamtstrom kleiner ist als in der Gleichrichterdiode nach Fig. 3 mit homogener Elektronensenke, wird dagegen die Speicherladung im Überstromfall durch die verringerte Stromdichte nur wenig oder gar nicht reduziert (Fig. 5). Durch die höhere Speicherladung in der Gleichrichterdiode nach Fig. 6 wird nicht nur die gesamte über die Fläche integrierte Verlustleistung, sondern auch die lokale Verlustleistung in den Bereichen C hoher Stromdichte bei gegebenem Gesamtstrom reduziert, so daß der zulässige Überstrom erhöht ist. Auch der Gesamtkomplex aus Recovery- und Auch der Gesamtkomplex aus Recovery- und Überstromeigenschaften ist gegenüber einer homogenen Anordnung der Elektronensenke ohne gut injizierende $P^+$-Zonen 2c verbessert, da das Verhältnis der Speicherladung bei normalen Betriebsströmen zu der im Überstromfall kleiner ist. Dies gilt auch gegenüber dem Fall, daß die Oberflächenkonzentration der schwach dotierten Zone 2a oder die Dicke der hoch dotierten Zone 2b in Fig. 3 und 4 in gewissem Maße heraufgesetzt wird, um auf diese Weise bei der Gleichrichterdiode nach Fig. 3 eine höhere Überstromfestigkeit zu erzielen.

Wie nicht weiter dargestellt, kann die Halbleiterscheibe nach Fig. 6 auch mit der P-Zone 2 auf der Trägerplatte 7 aufliegen, während die $N^+$-Zone 4 dann mit der Kontaktierungsschicht 9 versehen ist.

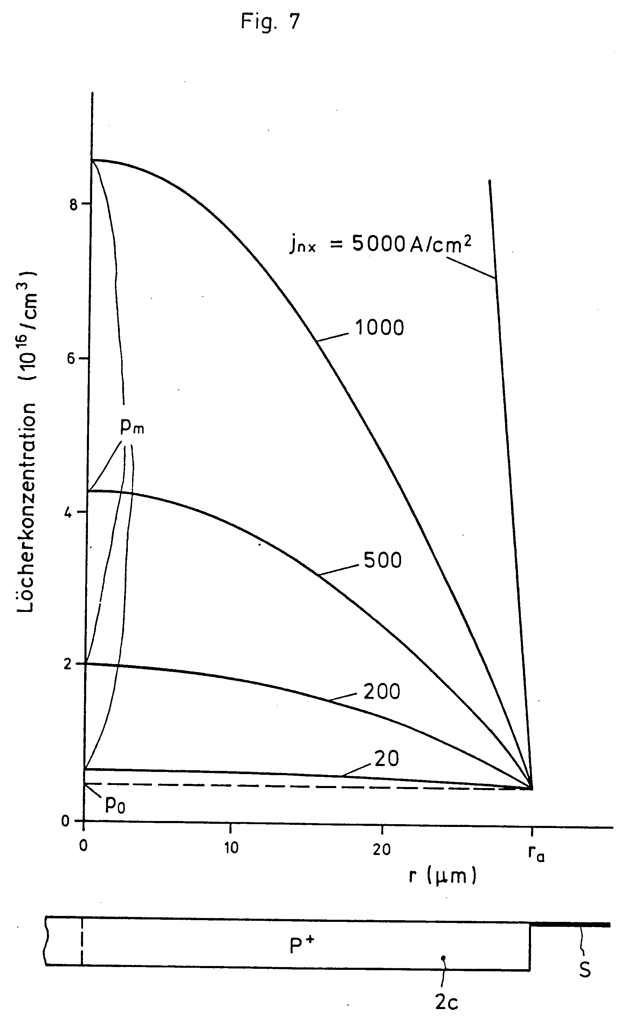

Bei den vorstehenden Ausführungen bezüglich der durch die Zonen 2c erreichten Verbesserungen wurden Effekte am Rande dieser Zonen nicht berücksichtigt. Die $P^+P$-Übergänge $J_3$ werde am Rande der $P^+$-Zonen 2c durch die Metallschicht 9 nahezu auf thermischen Gleichgewicht gehalten, so daß diese Zonen am Rande nicht injizieren. Erst mit wachsendem Abstand vom Rand werden die $P^+P$-Übergänge $J_3$ bei Durchlaßpolung der Gleichrichterdiode durch Elektronenströme, die in der P-Zone 2a an den Übergängen $J_3$ entlang zur Elektronensenke S fließen, zunehmend in Vorwärtsrichtung gepolt. Die lateral veränderliche Injektion hat eine örtliche Variation der Löcherkonzentration in der P-Zone 2a an der Grenze zu einer $P^+$-Zone 2c zur Folge. Für kreisförmige $P^+$-Zonen 2c mit einem Radius von nur 30 $\mu$m ist dies für verschiedene vertikale Elektronenstromdichten $j_{nx}$ in den Bereichen C am PN-Übergang $J_1$ in Fig. 7 dargestellt. Die Dotierungskonzentration der P-Zone 2a unmittelbar vor der $P^+$-Zone 2c ist $p_o = 5 \times 10^{15}/cm^3$, und die Elektronensenke (Oberfläche) schließt sich auf der Ebene des $P^+P$-Übergangs $J_3$ an die $P^+$-Zone 2c an. Wie aus der Figur ersichtlich, ist die Löcherkonzentration p am Rande bei $r = r_a$ gleich der Dotierungskonzentration $p_o$ der P-Zone 2a, in der Mitte bei $r = o$ nimmt p seinen Maximalwert $p_m$ an. Die injizierte Löcherkonzentration für $r < r_a$ nimmt für höhere Ströme stark mit der Elektronenstromdichte $j_{nx}$ zu. Dies gilt in ähnlicher Weise auch für die Abhängigkeit von der Gesamtstromdichte, die zusätzlich noch den Löcherstrom enthält und somit größer ist. Bis $j_{nx} = 200\ A/cm^2$ ist in der Zone 2a die über die Fläche gemittelte Löcherkonzentration $\bar{p}$, die das Recovery-Verhalten bestimmt, noch nicht stark angestiegen. Nehmen die $P^+$-Zonen 2c beispielsweise 1/3 der anodenseitigen Gesamtfläche in Anspruch, dann ist in dem Beispiel nach Fig. 7 mit $j_{nx} = 200\ A/cm^2$ die über die Gesamtfläche gemittelte Konzentration $\bar{p}$ erst um rund 50 % größer als $p_o$. Bei $j_{nx} = 1000\ A/cm^2$ aber ist $\bar{p}$ unter den gleichen Bedingungen schon um etwa 300 % größer, bei 5000 $A/cm^2$ etwa um den Faktor 20. Bei sehr hohen Stromdichten nähert sich der Maximalwert $p_m$ und auch die gemittelte Ladungsträgerkonzentration $\bar{p}$ am PN-Übergang $J_1$ der Löcherkonzentration im Fall einer einzigen oder weniger großflächiger P$^+$-Zonen 2c mit insgesamt gleichem Flächenanteil an, da der Randeinfluß bei hohen Stromdichten abnimmt.

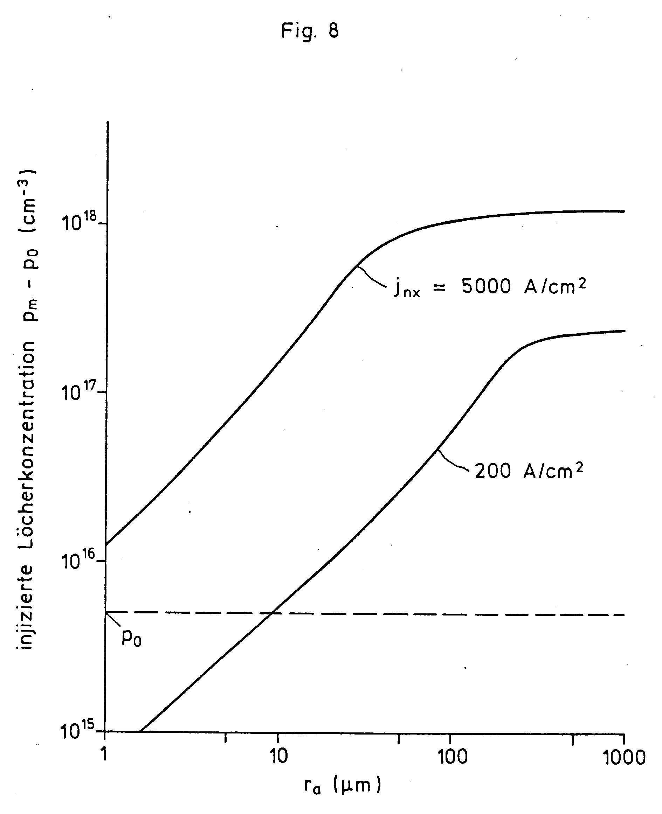

Die Abhängigkeit der maximalen injizierten Löcherkonzentration $p_m$-$p_o$ bei r = o vom Radius $r_a$ der P$^+$-Zonen 2c ist für zwei Stromdichten $j_{nx}$ in den Bereichen C in Fig. 8 dargestellt. Der Kurvenverlauf für 200 A/cm$^2$ kennzeichnet das Injektionsvermögen der P$^+$-Zonen 2c für betriebsmäßige Durchlaßstromdichten, während der Kurvenverlauf für 5000 A/cm$^2$ die Injektion der P$^+$-Zonen 2c bei Überstrombelastungen kennzeichnet. $p_m$-$p_o$ nimmt zunächst stark mit $r_a$ zu und geht bei großem $r_a$ in den durch die Volumeneigenschaften der P$^+$-Zonen gegebenen Sättigungswert über. Wie ersichtlich, kann das Verhältnis der injizierten Löcherkonzentration bei Betriebsströmen zu der bei Überstrombelastung durch Wahl eines kleinen Radius $r_a$ wesentlich unter das Verhältnis dieser Konzentration bei großflächigen P$^+$-Zonen 2c (Sättigungsbereich) herabgemindert werden. Zweckmäßg wird $r_a$ derart gewählt, daß die Löcherinjektion bei Betriebsströmen nur so groß ist wie für die maximal zulässige Durchlaßspannung erforderlich, während die Löcherinjektion bei Überströmen möglichst nahe an den Sättigungswert herankommt. Sind beide Bedingungen gleichzeitig nicht in vollem Maße erfüllbar, so muß ein Kompromiß geschlossen werden, der je nach vorgesehenem Einsatz der Gleichrichterdiode näher bei maximaler Überstromfestigkeit oder näher bei bestmöglichem Recovery-Verhalten liegen kann. In jedem Fall kann die Löcherinjektion bei Betriebsströmen verglichen mit dem Fall großflächiger P$^+$-Zonen 2c mit gleichen Flächenanteil stark reduziert werden, ohne die Überstromfestigkeit zu beeinträchtigen. Erreicht die lateral gemittelte Injektion bei Überstrom schon nahezu den Grenzwert, so sit die Überstromfestigkeit bei Verwendung vieler relativ kleiner P$^+$-Zonen 2c sogar erhöht, weil die Verlustleistung gleichmäßiger über die Halbleiterfläche verteilt und die Wärmeableitung somit verbessert ist. Wegen der stark reduzierten Injektion der P-Zone 2 bei Betriebsströmen, ergibt sich trotz der hohen Überstromfestigkeit ein wesentlich verbessertes Recovery-Verhalten. Die beschriebene Stromkonzentration auf die Bereiche C ist um so geringer, je dichter die Durchsetzung der Halbleiterfläche mit den P$^+$-Zonen 2c und je kleiner deren Radius $r_a$ ist, da die Querdiffusion dann einen stärkeren lateralen Ladungsträgerausgleich zur Folge hat.

Wird $r_a$ beispielsweise gleich 50 µm gewählt, ergibt sich bei Betriebsströmen für die Löcherinjektion $p_m$-$p_o$ = 2,6 x 10$^{16}$/cm$^3$. Nehmen die P$^+$-Zonen 2c wie in obigem Beispiel 1/3 der anodenseitigen Gesamtfläche der Gleichrichterdiode in Anspruch, dann entspricht dem eine über die Fläche gemittelte injizierte Löcherkonzentration $\bar{p}$ von nur etwa 4 x 10$^{15}$/cm$^3$. Zusammen mit einer Dotierungskonzentration $p_o$ an der Oberfläche der P-Teilzone 2a von z. B. 5 x 10$^{15}$/cm$^3$ reicht diese Injektion für eine genügend kleine Durchlaßspannung bei Betriebsströmen bei einer Dimensionierung für ein Sperrvermögen bis zu etwa 1800 V aus, jedoch ist $\bar{p}$ noch so klein, daß sich ein sehr gutes Recovery-Verhalten ergibt. Die Injektion bei Überstrombelastung ist bei diesem $r_a$ nahezu schon gleich dem Sättigungswert bei großen Flächen, wie aus Fig. 8 ersichtlich.

Da die Durchlaßspannung mit der Dicke der N-Basiszone 3, d. h. auch mit dem dimensionierten Sperrvermögen ansteigt, ist dies bei der Einstellung der mittleren P-Emitterwirksamkeit durch den Radius $r_a$ und den Flächenanteil der P$^+$-Zonen 2c an der Gesamtfläche zu berücksichtigen. Bei hohem Sperrvermögen ist die P-Emitterwirksamkeit bei Betriebsströmen größer zu wählen als bei kleinem, damit die Durchlaßspannung nicht zu groß wird.

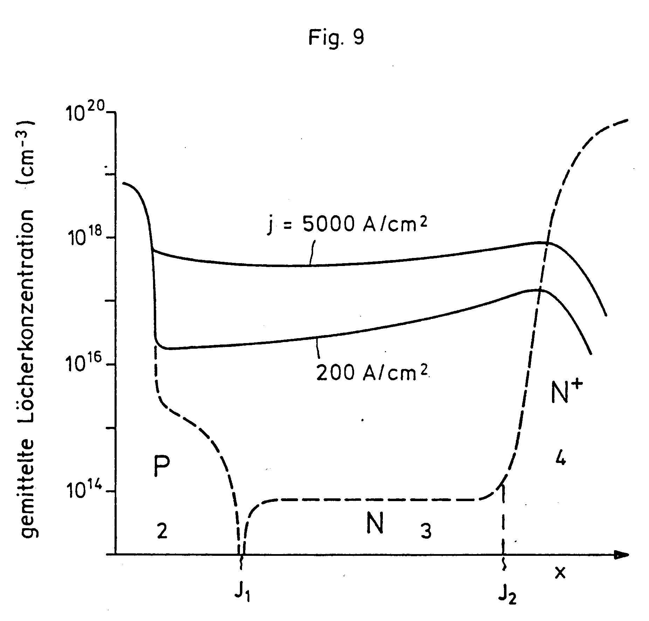

Der prinzipielle Einfluß einer relativ dichten Bedeckung der anodenseitigen Halbleiterfläche mit P$^+$-Zonen 2c auf die lateral gemittelte injizierte Löcherkonzentration p im Betriebs- und Überstromfall, ist aus Fig. 9 ersichtlich. Die laterale Ausdehnung der P$^+$-Zonen 2c ist dabei gemäß den in Zusammenhang mit Fig. 8 gemachten Angaben gewählt. Bei Betriebsströmen ist $\bar{p}$ in der Umgebung des PN-Übergangs $J_1$ wesentlich kleiner als am NN$^+$-Übergang $J_2$, wie durch den Kurvzug für 200 A/cm$^2$ angedeutet. Daraus ergibt sich, wie vorstehend beschrieben, ein ähnlich gutes Recovery-Verhalten wie bei der Gleichrichterdiode nach Fig. 3. Bei Überströmen aber ist die gemittelte Löcherkonzentration am PN-Übergang $J_1$ annähernd gleich der am NN$^+$-Übergang $J_2$ und verglichen mit der in Fig. 5 dargestellten Ladungsträgerverteilung der Gleichrichterdiode nach Fig. 3 stark angehoben, wie aus den Kurvenzügen für 5000 A/cm$^2$ in Fig. 9 und 5 hervorgeht. Dadurch ergibt sich ein wesentlich verbessertes Überstromverhalten der Gleichrichterdiode nach Fig. 6 mit der anhand von Fig. 7 und Fig. 8 erläuterten Dimensionierung.

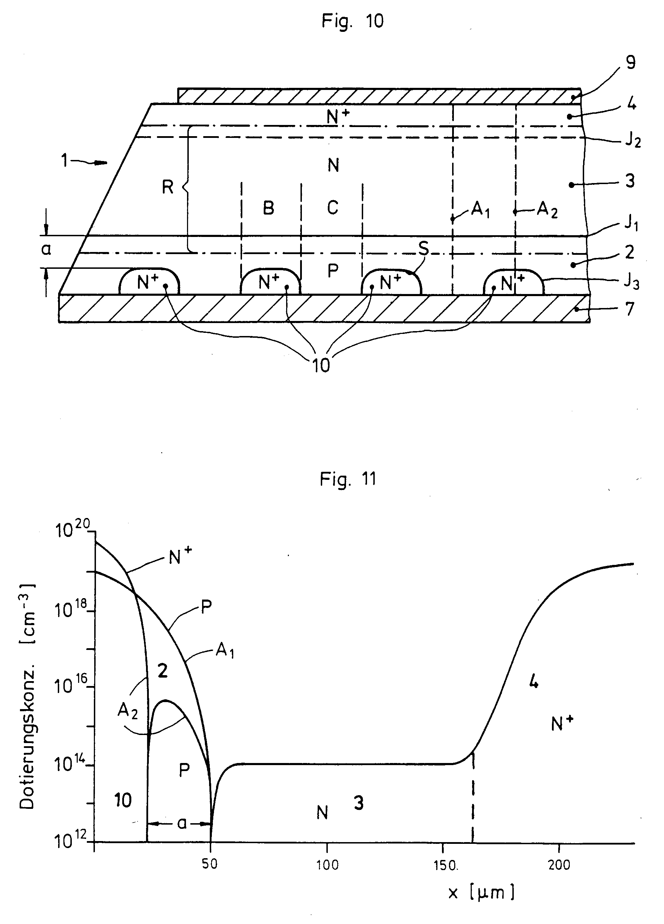

Wie aus Fig. 10 ersichtlich, kann die Elektronensenke S auch durch n-leitende Oberflächenzonen 10 gebildet sein, die in der P-Zone 2 liegen und mit dieser einen PN-Übergang $J_3$ bilden. Die n-leitenden Oberflächenzonen 10 sind als hoch dotierte N$^+$-Zonen ausgebildet. Sie sind an der Oberfläche zusammen mit der P-Zone 2 durch eine Metallschicht 7 kontaktiert. Die N$^+$-Zonen 10 haben eine geringere Dicke als die P-Zone 2, die mit der an sie anliegenden schwach dotierten N-Basiszone 3 den durchgehenden PN-Übergang $J_1$ bildet. An die N-Basiszone 3 schließt sich die hoch dotierte N$^+$-Zone 4 an, die mit der N-Basiszone 3 den NN$^+$-

Übergang $J_2$ bildet und an der Oberfläche mit der Kontaktierungsschicht 9 versehen ist. Die Dicke a und die Dotierungskonzentration des den $N^+$-Zonen 10 vorgelagerten Bereichs der P-Zone 2 sind so groß gewählt, daß die Ausdehnung der Raumladungszone R bei Sperrbelastung nicht bis zu den $N^+$-Zonen 10 reicht. Damit garantiert der PN-Übergang $J_1$ das gewünschte Sperrvermögen der Gleichrichterdiode. Weiter sind die Dicke a und die Dotierungskonzentration des vorgelagerten Bereichs der P-Zone 2 aber so klein gewählt, daß der Bereich hoher Injektion bei Durchlaßbetrieb bis nahe an die $N^+$P-Übergänge $J_3$ heranreicht, die bei Durchlaßpolung der Diode in Sperrichtung gepolt sind und daher zusammen mit der sich jeweils anschließenden $N^+$-Zone 10 als Senke für die Elektronen wirken. Diese Bedingungen lassen sich ähnlich wie in Zusammenhang mit Fig. 3 erläutert durch die integrale Netto-Do,tierung $N_{int}$ = $\int Ndx$ oder den Flächenwiderstand $R_\square$ des den $N^+$Zonen 10 in den Bereichen B vorgelagerten Bereichs der P-Zone 2 ausdrücken. Bei der Ausbildung nach Fig. 10 muß die P-seitige Grenze der Raumladungszone R jedoch zum Unterschied von den Ausbildungen nach Fig. 3 und 6 einen deutlichen Abstand von der Elektronensenke S einhalten, damit der aus $N^+$-Zonen 10, P-Zone 2 und N-Basiszone 3 gebildete NPN-Transistor bei Sperrbelastung der Gleichrichterdiode nicht durch Punch-through vorzeitig in den Durchbruch geht, worauf weiter unten genauer eingegangen wird. Vorteilhaft wird die integrale Dotierung und der Flächenwiderstand der P-Zone 2 in den Bereichen B nach folgenden Ungleichungen gewählt:

$$2 \times 10^{12}/cm^2 \lesssim N_{int} \lesssim 2 \times 10^{13}/cm^2$$
$$7 \text{ k}\Omega \gtrsim R_\square \gtrsim 1 \text{ k}\Omega$$

Die Dicke der P-Zone in den Bereichen B wird zweckmäßig größer als etwa 5 $\mu$m und kleiner als etwa 50 $\mu$m gewählt, die Dotierungskonzentration in diesem Bereich der P-Zone 2 liegt im Maximum vorteilhaft zwischen etwa 3 x $10^{15}/cm^3$ und 3 x $10^{16}/cm^3$.

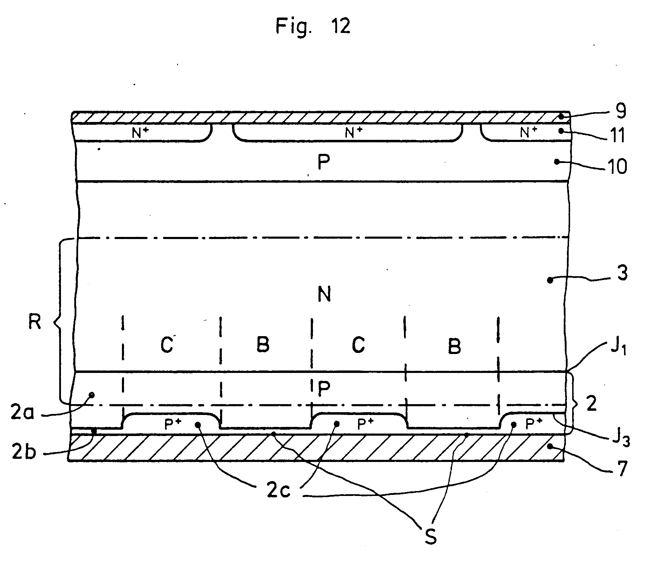

Ein Beispiel für den Dotierungsverlauf der Gleichrichterdiode nach Fig. 10 in den Schnitten $A_1$, $A_2$ ist in Fig. 11 dargestellt, und zwar ist der Verlauf der Netto-Dotierung wiedergegeben, d. h. der Differenz aus Akzeptor- und Donatordotierungskonzentration, absolut genommen. Die P-Zone 2 hat an der Oberfläche im Schnitt $A_1$ eine Dotierungskonzentration von 1 x $10^{19}/cm^3$, in dem den $N^+$-Zonen 10 vorgelagerten Bereich im Schnitt $A_2$ beträgt die Netto-Do tierung im Maximum. 6 x $10^{15}/cm^3$. Die Dicke der P-Zone 2 beträgt 50 $\mu$m, die Dicke a des vorgelagerten Bereichs 27 $\mu$m. Die $N^+$-Zonen 10 haben eine Netto-Oberflächendotierung von 5 x $10^{19}/cm^3$ und eine Dicke von 23 $\mu$m.

Die Gleichrichterdiode nach Fig. 10 mit dem Dotierungsprofil nach Fig. 11 hat den Vorteil, daß sie nach bekannten Diffusions- und Markierungsverfahren einfach herstellbar ist. Die Oberflächenkonzentration der P-Zone 2 braucht nicht so klein eingestellt zu werden wie die der Zone 2a der Gleichrichterdioden nach Fig. 3 und 6.

Bei Sperrbelastung der Gleichrichterdiode nach Fig. 10 sind die $N^+$P-Übergänge $J_3$ zwischen der $N^+$-Zonen 10 und der P-Zone 2 in Vorwärtsrichtung gepolt. Diese Vorwärtspolung wird durch den Querspannungsabfall in dem den $N^+$-Zonen 10 vorgelagerten P-Gebiet in den Bereichen B durch den an den $N^+$-Zonen 10 vorbeifließenden Rückwärtslöcherstrom verursacht. Im stationären Sperrzustand ist der Querspannungsabfall und damit die Vorwärtspolung der $N^+$P-Übergänge $J_3$ infolge des geringen Sperrstroms gering. Bei Kommutierung aus dem Durchlaß jedoch ist die Vorwärtspolung der $N^+$P-Übergänge $J_3$ während der Recovery-Phase größer. Die dadurch verursachte Aufsteuerung des aus den $N^+$-Zonen 10, der P-Zone 2 und der N-Basiszone 3 gebildeten NPN-Transistors kann zu einer wesentlichen Erhöhung des Recoverystroms und außerdem zu einem Durchbruch des NPN-Transistors und damit der Gleichrichterdiode unterhalb des stationären Sperrvermögens führen. Beides wird vermieden, indem der Abstand der Raumladungszone von den $N^+$P-Übergängen $J_3$ bei der maximalen Sperrbelastung genügend groß und die laterale Ausdehnung der $N^+$-Zonen 10 genügend klein gewählt werden. Der Abstand der Raumladungszone R von den $N^+$-Zonen 10 beeinflußt zunächst über den Flächenuiderstand des verbleibenden neutralen Teils der P-Zone 2 in den Bereichen B den Querspannungsabfall und damit die Höhe der Vorwärtspolung der $N^+$P-Übergänge $J_3$. Darüber hinaus bestimmt dieser Abstand über den Gradienten der Minoritätsträgerkonzentration im neutralen Teil der P-Zone 2 in den Bereichen B den von den $N^+$-Zonen 10 bei gegebener Vorwärtspolung in die Raumladungszone R fließenden Elektronenstrom. Diese Abhängigkeiten sind bei der obigen Festlegung der integralen Dotierung $N_{int}$ und des Flächenwiderstandes $R_\square$ der gesamten vorgelagerten P-Zone 2 in den Bereichen B berücksichtigt. Wird beispielsweise $N_{int}$ = 4 x $10^{12}/cm^2$ gewählt, so hat das bei der maximalen Sperrspannung noch vorhandene neutrale Gebiet noch etwa 2/3 des Flächenleitwertes der gesamten P-Zone 2 in den Bereichen B. Der für die Vorwärtspolung der $N^+$P-Übergänge $J_3$ maßgebende Flächenleitwert der vorgelagerten P-Zone 2 ist aber bei Rückströmen von beispielsweise 100 A/$cm^2$ durch freie Ladungsträger mit einer Konzentration in der Raumladungszone von größenordnungsmäßig $10^{15}/cm^3$ merklich erhöht. Zudem ist der Rückstrom in den Bereichen B infolge der geringeren injizierten Ladungsträgerkonzentration während der Durchlaßphase kleiner als in den Bereichen C hoher Emitterwirksamkeit, so daß auch der laterale Löcherstrom in der P-Zone 2 in den Bereichen B entsprechend reduziert ist. Ist die Dicke w der N-Basiszone 3 kleiner als der Radius $R_a$ der $N^+$-Zonen 10, wenn diese inselförmig mit einer kreisförmigen Grundfläche ausgebildet sind, so trägt im wesentlichen nur eine Randzone der Bereiche B mit einer Ausdehnung in der Größenordnung der N-Basisdicke w zur Vorwärtspolung der $N^+P$-Übergänge $J_3$ bei. Die kleinste der beiden Größen $R_a$ und w darf nicht größer sein als eine Länge $l_o$, die in reziproker Weise von der auftretenden Rückstromdichte und dem Flächenwiderstand der P-Zone 2 in den Bereichen B abhängt. Für Gleichrichterdioden mit einem Sperrvermögen oberhalb 1000 V, bei denen $w_n$ größer als etwa 70 µm ist, wird $R_a$ für typische Werte des Flächenwiderstandes unter Berücksichtigung der bei dieser Struktur auftretenden Rückströme kleiner als etwa 40 µm gewählt.

Bei den vorstehenden Ausführungen ist entsprechend den Dotierungsverläufen nach Fig. 11 eine hohe Emitterwirksamkeit der $N^+$-Zonen 10 zugrunde gelegt. Obwohl die Oberflächendotierungskonzentration dieser Zonen 10 für eine gute Kontaktierbarkeit groß sein soll, kann die Emitterwirksamkeit der $N^+P$-Übergänge $J_3$ jedoch durch eine geringe Dicke der $N^+$-Zonen 10 klein eingestellt werden. In diesem Fall dürfen die lateralen Abmessungen der $N^+$-Zonen 10 größer gewählt werden.

Wie bereits für die Gleichrichterdiode nach Fig. 6 im Einzelnen erläutert, hat die flächmäßig nur in Teilbereichen angeordnete Elektronensenke S auch bei der Ausbildung nach Fig. 10 ein gegenüber der Gleichrichterdiode nach Fig. 3 verbessertes Überstromverhalfen zur Folge. Ob die Elektronensenke S inselartig ausgebildet und der Komplementärbereich C hoher Emitterwirksamkeit zusammenhängend ist oder wie bei der in Fig. 7 und 8 zugrunde gelegten Anordnung, die Bereiche C hoher Emitterwirksamkeit inselartig ausgebildet sind und die Elektronensenke S einen zusammenhängenden Bereich bildet oder ob noch ein anderes Oberflächenmuster für die Aufteilung der Fläche in die Bereiche B und C gewählt wird, ist nicht wesentlich. Für die Ausnutzung des anhand von Fig. 7 und 8 erläuterten Randeffektes ist allgemein die laterale Ausdehnung der Bereiche B, d. h. der maximale Abstand der Punkte der Bereiche B von der nächsten Elektronensenke, so zu wählen, daß die über die Fläche gemittelte Löcherinjektion bei Betriebsstromdichten möglichst klein ist, während sie bei Überstromen nahezu den Sättigungswert im Fall großflächiger Bereiche C annimmt.

Die Anwendung einer der vorstehend beschriebenen P-Emitterstrukturen mit einer Elektronensenke S auf einen Thyristor zeigt Fig. 12. Die anodenseitige P-Zone 2 besteht wie bei der Gleichrichterdiode nach Fig. 6 aus einer durchgehenden schwach dotierten Teilzone 2a, einer dünnen hoch dotierten $P^+$-Teilzone 2b in den Bereichen B, die in diesen Bereichen zur Kontaktierung dient, und relativ dicken hoch dotierten $P^+$-Teilzonen 2c hoher Emitterwirksamkeit in den Bereichen C. Die P-Zone 2 ist an der Oberfläche mit einer durchgehenden Kontaktierungsschicht 7 versehen. Nach innen schließt sich an die P-Zone 2 die schwach dotierte N-Basiszone 3 an, worauf wie bei der üblichen Thyristorstruktur die p-leitende Steuerbasiszone 10 und die n-leitende kathodenseitige Emitterzone 11 folgen, die an der Oberfläche mit einer Kontaktierungsschicht 9 versehen sind. Die Dimensionierung der P-Zone 2 kann gemäß den in Verbindung mit den Figuren 7 und 8 gemachten Angaben erfolgen.

Wie für die vorstehend beschriebenen Gleichrichterdioden in Fig. 9 gezeigt, bewirkt die P-Zone 2 bei betriebsmäßigen Durchlaßstromdichten (200 A/cm²) eine zur P-Zone 2 hin abfallende Ladungsträgerkonzentration in der Thyristorstruktur. Wie anhand der Fig. 1 erläutert, hat dies auch für den Thyristor eine Verkleinerung der Rückstromspitze und des Rückstromintegrals nach Kommutierung zur Folge. Infolge des mit dem Durchlaßstrom zunehmenden Injektionsvermögens der P-Zone 2 (Fig. 7 bis 9) ist der zulässige Überstrom nicht reduziert. Bei der Dimensionierung der P-Zone im Thyristor muß außer den in Verbindung mit den in Fig. 7 und 8 gemachten Angaben berücksichtigt werden, daß der Zünd- und Einraststrom des Thyristors nicht über vorgegebene Grenzen erhöht wird. Dies kann durch eine geringere zusätzliche Rekombinationszentrendichte oder durch eine Anhebung der Oberflächenkonzentration der P-Teilzone 2a im Vergleich zur Gleichrichterdiode erfolgen.

## Patentansprüche

1. Halbleiterbauelement mit einer anodenseitigen P-Zone (2), die an der Oberfläche mindestens in Teilbereichen eine höhere Dotierungskonzentration und eine für höher sperrende Bauelemente ausgelegte Dicke hat, mit einer an die P-Zone (2) angrenzenden schwach dotierten N-Basiszone (3), die mit der P-Zone (2) einen PN-Übergang ($J_1$) bildet, und mit einer vom PN-Übergang ($J_1$) beabstandeten Senke (S) für Elektronen, wobei die Dicke und Dotierung der P-Zone (2) so aufeinander abgestimmt sind, daß die Ausdehnung der Raumladungszone (R) bei Sperrbelastung nicht bis zur Senke (S) reicht, **dadurch gekennzeichnet,** daß die integrale Netto-Dotierung ($N_{int}$) der P-Zone (2) zwischen der Senke (S) und dem PN-Übergang ($J_1$) größer als etwa $1,3 \times 10^{12}$/cm²

und kleiner als etwa $2 \times 10^{13}/\text{cm}^2$ ist, und daß Dicke und Dotierung der P-zone (2) so aufeinander abgestimmt sind, daß bei Durchlaßbelastung die Senke (S) wirksam wird.

2. Halbleiterbauelement nach Anspruch 1,
   **dadurch gekennzeichnet,**
   daß die P-Zone (2) aus einer schwach dotierten durchgehenden inneren P-Teilzone (2a) und einer hoch dotierten $P^+$-Oberflächenzone (2b) geringer Emitterwirksamkeit besteht.

3. Halbleiterbauelement nach Anspruch 2,
   **dadurch gekennzeichnet,**
   daß die P-Zone (2) neben der $P^+$-Oberflächenzone (2b) geringer Emitterwirksamkeit in Teilbereichen der Fläche hoch dotierte $P^+$-Oberflächenzonen (2c) hoher Emitterwirksamkeit aufweist.

4. Halbleiterbauelement nach Anspruch 1,
   **dadurch gekennzeichnet,**
   daß die P-Zone (2) aus einer schwach dotierten, durchgehenden, inneren P-Teilzone (2a) und in Teilbereichen der Fläche angeordneten $P^+$-Oberflächenzonen (2c) hoher Emitterwirksamkeit besteht.

5. Halbleiterbauelement nach Anspruch 2 oder einem der folgenden,
   **dadurch gekennzeichnet,**
   daß die integrale Dotierung der inneren P-Teilzone (2a) größer als etwa $1,3 \times 10^{12}/\text{cm}^2$ und kleiner als $1 \times 10^{13}/\text{cm}^2$ ist.

6. Halbleiterbauelement nach Anspruch 2 oder einem der folgenden,
   **dadurch gekennzeichnet,**
   daß die Dicke der inneren P-Teilzone (2a) größer als etwa 5 $\mu$m und kleiner als etwa 70 $\mu$m und deren maximale Dotierungskonzentration größer als etwa $1 \times 10^{15}/\text{cm}^3$ und kleiner als etwa $2 \times 10^{16}/\text{cm}^3$ ist.

7. Halbleiterbauelement nach Anspruch 2, 3, 5 oder 6,
   **dadurch gekennzeichnet,**
   daß die Dicke der $P^+$-Oberflächenzone (2b) geringer Emitterwirksamkeit so klein gewählt ist, daß bei Durchlaßbelastung der von der N-Basiszone (3) kommende Elektronenstrom durch die $P^+$-Oberflächenzone (2b) zur Senke für Elektronen (S) an der Oberfläche fließen kann.

8. Halbleiterbauelement nach Anspruch 7,
   **dadurch gekennzeichnet,**
   daß die Dicke der $P^+$-Oberflächenzone (2b)

kleiner als 2 $\mu$m und deren Dotierungskonzentration an der Oberfläche größer als $3 \times 10^{17}/\text{cm}^3$ ist.

9. Halbleiterbauelement nach Anspruch 3 oder einem der folgenden,
   **dadurch gekennzeichnet,**
   daß die $P^+$-Oberflächenzonen (2c) hoher Emitterwirksamkeit in ihrer lateralen Ausdehnung derart bemessen sind, daß deren Löcherinjektion bei betriebsmäßigen Durchlaßströmen auf das für die maximale Durchlaßspannung bei diesen Strömen erforderliche Maß reduziert ist.

10. Halbleiterbauelement nach Anspruch 3 oder einem der folgenden,
    **dadurch gekennzeichnet,**
    daß die $P^+$-Oberflächenzonen (2c) hoher Emitterwirksamkeit in ihrer lateralen Ausdehnung derart bemessen sind, daß deren Löcherinjektion bei betriebsmäßigen Durchlaßströmen reduziert ist, jedoch bei Überströmen voll wirksam wird.

11. Halbleiterbauelement nach Anspruch 9 oder 10,
    **dadurch gekennzeichnet,**
    daß die $P^+$-Oberflächenzonen (2c) hoher Emitterwirksamkeit eine kreisförmige Grundfläche mit einem Radius ($r_a$) zwischen etwa 30 $\mu$m und 100 $\mu$m haben.

12. Halbleiterbauelement nach Anspruch 1,
    **dadurch gekennzeichnet,**
    daß die Senke für Elektronen (S) mittels in der P-Zone (2) angeordneter n-leitender Oberflächenzonen (10) gebildet ist.

13. Halbleiterbauelement nach Anspruch 12,
    **dadurch gekennzeichnet,**
    daß die lateralen Abmessungen oder die Emitterwirksamkeit der n-leitenden Oberflächenzonen (10) so klein gewählt sind, daß diese Zonen bei Rückwärtspolung des Halbleiterbauelements nicht wesentlich injizieren.

14. Halbleiterbauelement nach Anspruch 13,
    **dadurch gekennzeichnet,**
    daß die n-leitenden Oberflächenzonen (10) eine kreisförmige Grundfläche mit einem Radius kleiner als etwa 40 $\mu$m haben.

15. Halbleiterbauelement nach Anspruch 12 oder einem der folgenden,
    **dadurch gekennzeichnet,**
    daß der gegenseitige Abstand der n-leitenden Oberflächenzonen (10) derart bemessen ist, daß die Löcherinjektion der P-Zone (2) bei betriebsmäßigen Durchlaßströmen auf das für die maximale Durchlaßspannung bei diesen Strömen erforderliche Maß reduziert ist.

16. Halbleiterbauelement nach Anspruch 12 oder einem der folgenden, **dadurch gekennzeichnet,** daß der gegenseitige Abstand der n-leitenden Oberflächenzonen (10) derart bemessen ist, daß die Löcherinjektion bei betriebsmäßigen Durchlaßströmen reduziert ist, jedoch bei Überströmen voll wirksam wird.

**Claims**

1. Semiconductor component having an anode-side p-zone (2) which has on the surface, at least in subregions, a higher doping concentration and a thickness designed for higher blocking components, having a weakly doped n-base zone (3) which is adjacent to the p-zone (2) and forms a pn-junction ($J_1$) with the p-zone (2), and having an electron sink (S) at a distance from the pn-junction ($J_1$), the thickness and doping of the p-zone (2) being tuned to one another in such a way that the extent of the space charge region (R) does not reach as far as the sink (S) in the case of a blocking load, characterised in that the integral net doping $N_{int}$ of the p-zone (2) between the sink (S) and the pn-junction ($J_1$) is greater than approximately $1.3 \times 10^{12}/cm^2$ and less than approximately $2 \times 10^{13}/cm^2$, and in that the thickness and doping of the p-zone (2) are tuned to one another in such a way that the sink (S) becomes active in the case of the forward load.

2. Semiconductor component according to Claim 1, characterised in that the p-zone (2) comprises a weakly doped continuous internal p-subzone (2a) and a highly doped $p^+$-surface zone (2b) of low emitter efficiency.

3. Semiconductor component according to Claim 2, characterised in that in addition to the $p^+$-surface zone (2b) of low emitter efficiency the p-zone (2) has highly doped $p^+$-surface zones (2c) of high emitter efficiency in subregions of the surface.

4. Semiconductor component according to Claim 1, characterised in that the p-zone (2) comprises a weakly doped, continuous, internal p-subzone (2a) and $p^+$-surface zones (2c) of high emitter efficiency arranged in subregions of the surface.

5. Semiconductor component according to Claim 2 or one of the following claims, characterised in that the integral doping of the internal p-subzone (2a) is greater than approximately $1.3 \times 10^{12}/cm^2$ and less than $1 \times 10^{13}/cm^2$.

6. Semiconductor component according to Claim 2 or one of the following claims, characterised in that the thickness of the internal p-subzone (2a) is greater than approximately $5\ \mu m$ and less than approximately $70\ \mu m$ and its maximum doping concentration is greater than approximately $1 \times 10^{15}/cm^3$ and less than approximately $2 \times 10^{16}/cm^3$.

7. Semiconductor component according to Claim 2, 3, 5 or 6, characterised in that the thickness of the $p^+$-surface zone (2b) of low emitter efficiency is chosen to be so low that in the case of a forward load the electron current coming from the n-base zone (3) can flow through the $p^+$-surface zone (2b) to the electron sink (S) on the surface.

8. Semiconductor component according to Claim 7, characterised in that the thickness of the $p^+$-surface zone (2b) is less than $2\ \mu m$ and its doping concentration on the surface is greater than $3 \times 10^{17}/cm^3$.

9. Semiconductor component according to Claim 3 or one of the following claims, characterised in that the lateral extent of the $p^+$-surface zones (2c) of high emitter efficiency is dimensioned such that in the case of operational forward currents their hole injection is reduced to the dimension required for the maximum forward voltage in the case of these currents.

10. Semiconductor component according to Claim 3 or one of the following claims, characterised in that the lateral extent of the $p^+$-surface zones (2c) of high emitter efficiency is dimensioned such that their hole injection is reduced in the case of operational forward currents but becomes fully effective in the case of overcurrents.

11. Semiconductor component according to Claim 9 or 10, characterised in that the $p^+$-surface zones (2c) of high emitter efficiency have a circular base area with a radius ($r_a$) of between approximately $30\ \mu m$ and $100\ \mu m$.

12. Semiconductor component according to Claim 1, characterised in that the electron sink (S) is formed by means of n-conducting surface zones (10) arranged in the p-zone (2).

**13.** Semiconductor component according to Claim 12, characterised in that the lateral dimensions or the emitter efficiency of the n-conducting surface zones (10) are chosen to be so small that these zones do not inject substantially in the case of reverse polarity of the semiconductor component.

**14.** Semiconductor component according to Claim 13, characterised in that the n-conducting surface zones (10) have a circular base area with a radius of less than approximately 40 $\mu$m.

**15.** Semiconductor component according to Claim 12 or one of the following claims, characterised in that the mutual spacing of the n-conducting surface zones (10) is dimensioned such that in the case of operational forward currents the hole injection of the p-zone (2) is reduced to the dimension required for the maximum forward voltage in the case of these currents.

**16.** Semiconductor component according to Claim 12 or one of the following claims, characterised in that the mutual spacing of the n-conducting surface zones (10) is dimensioned such that the hole injection is reduced in the case of operational forward currents but becomes fully effective in the case of overcurrents.

**Revendications**

**1.** Composant à semiconducteurs comportant une zone de type P (2) située côté anode, qui possède au niveau de la surface et au moins dans des régions partielles, une concentration de dopage accrue et une épaisseur réglée pour des composants réalisant un blocage plus intense, et comportant une zone de base de type N (3) faiblement dopée et jouxtant la zone de type P (2) et qui forme, avec la zone de type P (2) une jonction PN ($J_1$), et un puits (S) pour des electrons, qui est distant de la jonction PN ($J_1$), l'épaisseur et le dopage de la zone de type P (2) étant réglés l'un sur l'autre de manière que l'étendue de la zone de charges d'espace (R) ne s'étende pas jusqu'au puits (S) pour une commande à l'état bloqué, caractérisé par le fait que le dopage net ($N_{int}$) de la zone de type P (2) entre le puits (S) et la jonction PN ($J_1$) est supérieur à environ 1,3 x $10^{12}$/cm$^2$ et inférieur à environ 2 x $10^{13}$/cm$^2$, et que l'épaisseur et le dopage de la zone de type P (2) sont réglés l'un sur l'autre de telle sorte que le puits (S) devient actif lors de la commande à l'état passant.

**2.** Composant à semiconducteurs suivant la revendication 1, caractérisé par le fait que la zone de type P (2) est constituée par une zone partielle intérieure continue de type P (2a) faiblement dopée et par une zone superficielle fortement dopée de type P$^+$ (2b) présentant une faible activité d'émetteur.

**3.** Composant à semiconducteurs suivant la revendication 2, caractérisé par le fait que la zone de type P (2) présente, dans des zones partielles de la surface, à côté de la zone superficielle de type P$^+$ (2b) présentant une faible efficacité d'émetteur, des zones superficielles fortement dopées de type P$^+$ (2c) présentant une activité élevée d'émetteur.

**4.** Composant à semiconducteurs suivant la revendication 1, caractérisé par le fait que la zone de type P (2) est constituée par une zone partielle intérieure continue faiblement dopée de type P (2a) et par des zones superficielles de type P$^+$ (2c) qui sont disposées dans des zones partielles de la surface et présentent une activité élevée d'émetteur.

**5.** Composant à semiconducteurs suivant la revendication 2 ou l'une des suivantes, caractérisé par le fait que le dopage intégral de la zone partielle intérieure de type P (2a) est supérieure à environ 1,3 x $10^{12}$/cm$^2$ et est inférieur à 1 x $10^{13}$/cm$^2$.

**6.** Composant à semiconducteurs suivant l'une des revendications 2 ou l'une des suivantes, caractérisé par le fait que l'épaisseur de la zone partielle intérieure de type P (2a) est supérieure à environ 5 $\mu$m et inférieure à environ 70 $\mu$m et que sa concentration maximale de dopage est supérieure à environ 1 x $10^{15}$/cm$^3$ et est inférieure à environ 2 x $10^{16}$/cm$^3$.

**7.** Composant à semiconducteurs suivant la revendication 2, 3, 5 ou 6, caractérisé par le fait que l'épaisseur de la zone superficielle de type P$^+$ (2b), qui présente une faible activité d'émetteur, est choisie suffisamment faible pour que, lors de la commande à l'état passant, le courant d'électrons, qui arrive de la zone de base de type N (3), puisse traverser la zone superficielle de type P$^+$ (2b) en direction du puits pour des électrons (S) au niveau de la surface.

**8.** Composant à semiconducteurs suivant la revendication 7, caractérisé par le fait que l'épaisseur de la zone superficielle de type P$^+$

(2b) est inférieure à 2 $\mu$m et que sa concentration de dopage au niveau de la surface est supérieure à 3 x $10^{17}$/cm$^3$.

9. Composant à semiconducteurs suivant la revendication 3 ou l'une des revendications suivantes, caractérisé par le fait que l'étendue latérale des zones superficielles de type P$^+$ - (2c), qui présentent une activité élevée d'émetteur, est dimensionnée de telle sorte que l'injection de trous, qu'elles réalisent, est réduite, dans le cas de la circulation de courants de conduction en fonctionnement, à la valeur requise pour la tension maximale de conduction, dans le cas de ces courants.

10. Composant à semiconducteurs suivant la revendication 3 ou l'une des revendications suivantes, caractérisé par le fait que l'étendue latérale des zones superficielles de type P$^+$ - (2c), qui présentent une activité élevée d'émetteur, est dimensionnée de telle sorte que l'injection de porteurs, qu'elles réalisent, est réduite pour des courants de conduction en fonctionnement, mais devient totalement active dans le cas de surintensités.

11. Composant à semiconducteurs suivant la revendication 9 ou 10, caractérisé par le fait que les zones superficielles de type P$^+$ (2c), qui présentent une activité élevée d'émetteur, possèdent une surface de base circulaire dont le rayon ($r_a$) est compris entre environ 30 $\mu$m et 100 $\mu$m.

12. Composant à semiconducteurs suivant la revendication 1, caractérisé par le fait que le puits pour des électrons (S) est formé au moyen de zones superficielles (10) conductrices du type n et disposées dans la zone de type P (2).

13. Composant à semiconducteurs suivant la revendication 12, caractérisé par le fait qu'on choisit pour les dimensions latérales ou l'activité d'émetteur des zones superficielles (10) conductrices de type n de faibles valeurs telles que ces zones ne réalisent sensiblement aucune injection lors de la polarisation inverse du composant à semiconducteurs.

14. Composant à semiconducteurs suivant la revendication 13, caractérisé par le fait que les zones superficielles (10) conductrices du type n possèdent une surface de base circulaire avec un rayon inférieur à environ 40 $\mu$m.

15. Composant à semiconducteurs suivant la revendication 12 ou l'une des revendications suivantes, caractérisé par le fait que la distance réciproque des zones superficielles (10) conductrices du type n est dimensionnée de telle sorte que l'injection des trous de la zone de type P (2) est réduite, pour des courants de conduction en fonctionnement, à la valeur nécessaire pour la tension maximale de conduction dans le cas de ces courants.

16. Composant à semiconducteurs suivant la revendication 12 ou l'une des revendications suivantes, caractérisé par le fait que la distance réciproque des zones superficielles (10) conductrice du type n est choisie de manière que l'injection des trous est réduite dans le cas de courants de conduction en fonctionnement, mais devient complètement active dans le cas de surintensités.

Fig. 1**b**

Fig. 1a

Fig. 2

Fig. 3

Fig. 4

Fig. 5

Fig. 6

## Fig. 7

Fig. 8

Fig. 9

Fig. 10

Fig. 11

Fig. 12